# EUROPEAN PATENT SPECIFICATION

(11) **EP 2 338 010 B1**
(45) Date of publication and mention of the grant of the patent: **10.07.2019**
(21) Application number: 09785670.2
(22) Date of filing: 18.09.2009
(51) Int. Cl.: H02S 30/10, H02S 20/22, F24S 20/67

(54) **Supporting frame for constructing a building including a thermal panel and a photovoltaic panel**
Tragwerk für den Bau eines Gebäudes mit einem Thermomodul und einem fotovoltaischen Modul
Support pour la construction d'un bâtiment comprenant un module thermique et un module photovoltaïque

(30) Priority: 19.09.2008 GB 0817173
(43) Date of publication of application: 29.06.2011
(73) Proprietor: Bankart, Richard David, London SW9 0DB (GB)
(72) Inventor: Bankart, Richard David, London SW9 0DB (GB)
(86) International application number: PCT/GB2009/051221
(87) International publication number: WO 2010/032063

(56) References cited:
- EP-A2- 0 828 036
- WO-A1-96/38695
- WO-A1-03/085329
- WO-A1-2008/020462
- WO-A1-2008/037016
- WO-A2-2007/030732
- WO-A2-2008/073905
- WO-A2-2008/106565
- DE-A1- 2 535 581
- DE-A1-102006 033 622
- DE-B3- 10 304 536
- DE-U1- 20 312 719
- JP-A- 11 036 541
- JP-A- H07 292 909
- JP-A- 2001 098 703
- US-A- 4 031 881
- US-A- 5 197 242
- US-A- 5 968 287
- US-A1- 2006 086 382
- US-B1- 6 336 304
- Riffel Siegfried: "iRoof / iWall - Strom, Wärme, Kühlung und hohe Wohnqualität mit dem intelligenten und multifunktionalen Fertigteilsystem aus Beton", , 26 January 2007 (2007-01-26), pages 1-11, XP055031775, Retrieved from the Internet: URL:http://www.beton.org/fileadmin/imagepo ol/bauherreninformationen/eigenheim/iRoof- iWall_Stand_11.06.pdf [retrieved on 2012-07-04]
- RIFFEL S: "ROOF/IWALL - STROM, WÄRME UND KÜHLUNG MIT INTELLIGENTEN FERTIGTEILEN AUS BETON - DAS KONZEPT//IROOF/IWALL - ELECTRICITY, HEATING AND COOLING THROUGH INTELLIGENT PRECAST ELEMENTS - THE CONCEPT", BFT INTERNATIONAL, BAUVERLAG, GUTERSLOH, DE, vol. 71, no. 2, 1 February 2005 (2005-02-01), page 50/51, XP001224768, ISSN: 0373-4331
- RIFFEL S.: "ROOF/IWALL - STROM, WÄRME UND KÜHLUNG MIT INTELLIGENTEN FERTIGTEILEN AUS BETON, 3rd Symposium Baustoffe und Bauwerkserhaltung", Betonbauinnovationen, 15 March 2006 (2006-03-15), pages 79-89, Universität Karlsruhe

## Description

### Field of the Invention

This invention relates to a device for constructing a building, in particular one that simultaneously provides weather protection, insulation and solar energy, capture (heat and/or power).

### Background to the Invention

With rising concerns over emissions of carbon dioxide and the increasing scarcity of fossil fuels it is becoming ever more difficult and expensive to rely upon these resources as a source of electricity. Therefore a growing market has been established for the exploitation of renewable resources. Solar power represents one of the most mature technologies for exploiting the natural resources available to us, and is therefore growing in popularity. However, it is difficult to build monolithic solar power plants which produce power comparable to traditional fuel-burning plants, because of the large area of solar panels that is required to achieve this output. One way to overcome this problem is to use small installations of solar panels in many locations, such as on rooftops. These solar panels can then be used to generate electricity, or to capture heat from the sun, for example.

Solar panels are often difficult to fit, being generally fragile. A method which allowed solar power to be incorporated quickly and easily into buildings would therefore be extremely desirable.

WO 2008/037016A1 discloses a roofing tile including a photovoltaic device, a thermal collector and a support member. The invention aims to improve the heat absorption of such a tile.

### Summary of the Invention

Accordingly, this invention provides a power generation member as defined in claim 1. Preferred embodiments are defined in the dependent claims.

In this way the invention provides a simple and effective method for constructing a building using parts which act as structural components as well as providing heat and/or electricity. Power generation members according to the invention can be manufactured off-site as complete integrated panels, before being taken to the construction site and simply fastened in place to form a wall or roof. Thus the member of the invention combines a solar panel with a roof or wall panel to greatly simplify the construction process and can also provide weather protection and insulation. It can replace rafters, panelling, insulation and roof covering along with many other components typically found in building construction. By incorporating energy converter in this way, the structural components of the building also act to support the energy converter, removing the need for a second support. All of these features offer large savings in both build time and cost of materials.

The framework may comprise wood, steel, concrete, plastic, glass reinforced plastic or any other suitable material or combination of materials. Typically, the framework may be the A-frame of a roof. The framework may also be the inner walls of a building.

The energy converter of the invention comprises a photovoltaic device, for example a thin film semiconductor device. Crystalline, thin film and die solar cells may all be used, for example. The energy converter also comprises at least one thermal collector, in addition to the photovoltaic device. In one embodiment, the power generation member comprises a third layer comprising a thermal collector, the third layer being secured between the first and second layers. Alternatively, the third layer may be substantially transparent and secured over the second layer; in this embodiment fluid will typically be passed through the third layer so that heat may be absorbed from the first layer. A thermal collector may both help to keep the photovoltaic devices cool and can be used to heat water, air or any other desired substance for subsequent use in and around the building, or for evaporative cooling.

In the presently preferred embodiment, a thermal collector comprises at least one metal pipe, the pipe being filled with a fluid in use, typically water. Alternatively, the pipe may be substantially evacuated in use except for an amount of a fluid such as water much smaller in volume than the inner volume of the pipe, when condensed. Alternatively, the thermal collector may simply comprise a pipe containing a suitable thermally conductive fluid, such as water, glycol, ammonia and the like.

The pipe may be straight, in which case a large number of parallel pipes will typically be used to cover the area beneath the photovoltaic device. Alternatively, a smaller number of pipes which curve or bend may be used to cover the same area.

Typically, the thermal collector comprises a flat plate, which may further comprise channels therein for the passage of fluid, which is extruded in manufacture so that it can readily be produced in the desired length, or cut to length subsequently. The extrusion can then be capped and sealed at either end by end caps designed to collect the fluid and direct it as required. Alternatively, flat plate collectors can be made from bonded or welded sheet metal and connected in the same manner. The thermal collector could also comprise an absorber plate with either (i) a coil/pipe or (ii) a heat pipe welded or bonded to its rear.

Metals are preferred for the thermal collector because of their high thermal conductivity. However, any thermally conductive material could be used. Conductivity is improved where the thickness of material is small. In some embodiments, a plastic membrane suffices to allow rapid conduction of heat to the transmission fluid: Water is preferred for the transmission fluid because of its high heat capacity, which allows a small amount of water to be used to move a large amount of heat, reducing the amount of energy wasted in conveying the heat to its eventual destination. However, other substances which are liquid or gaseous at suitable temperatures and pressures, such as glycol or air, could be used.

As well as pipes, solid heat conductors could also be used. For example, metal fins could be used to conduct heat to a desired destination, such as a reservoir of water at one end of the power generation member.

Typically, the power generation member further comprises a protective layer which may be transparent. The protective layer may be secured over the energy converter. The protective layer may comprise at least one layer of sheet metal, glass, for example low iron or low e glass, plastic or other transparent or translucent materials. Low iron glass is favoured because it has good transmittance characteristics in the solar spectrum. The transparent protective member may also comprise a low emissivity coating. Low emissivity glass and other similar materials are useful because they can reflects much of the infra red radiation emitted within the power generation member, helping the member to maintain its temperature where this is desirable. In some instances, it may be possible that the solar energy converter is embodied in the protective layer.

The protective layer can both protect the energy converter and help to retain heat for the thermal collector. There may be a space between the protective layer and the photovoltaic device which can, for example, be evacuated or filled with argon, carbon dioxide, or some other light transmitting, insulating material or gas to further increase the retention of heat. In any event the power generation member should preferably form a sealed unit. The interior of the power generation member may be provided with inhibitors to prevent a build-up of water vapour and/or microbes. Air glass may be used to fill any space in the power generation member.

Typically the support member comprises an insulating material of low thermal conductivity. The insulating material may be a mineral wool, a plastic such as polystyrene or polyurethane foam, a plant or animal product such as cellulose or sheep's wool, or any other suitable material. This will provide insulation for the building. Polyurethane can also provide structural rigidity and sealing of the power generation member. The support member comprises insulating material laid within a structure formed from a supporting material, such as wood, metal, concrete, plastic or glass reinforced plastic.

The pre-fabricated power generation member may be cut to length in situ or when fabricated. In this case, end caps may be provided to seal one or both ends of the power generation member. Such end caps may provide electrical and / or fluid connections to the energy converter. Where a thermal collector is formed from a plurality of parallel channels, an end cap may be provided to connect adjacent channels, whereby to form a serpentine fluid pathway.

### Brief Description of the Drawings

The following drawings show examples which are not according to invention; but are useful for understanding it.
- Figure 1: is a horizontal cross section of a first solar device;
- Figure 2: is a cross section of a dummy device;
- Figure 3: is a longitudinal cross section of the first solar device;
- Figure 4: is a longitudinal side view of the first solar device;
- Figures 5, 6 and 7: are drawings showing solar devices installed;
- Figure 8: is a cross section of an end piece;
- Figure 9: is a drawing showing a first and a second solar device;
- Figure 10: is a longitudinal cross section of a third solar device;
- Figure 11: shows a longitudinal cross section of a heat exchanger;
- Figure 12: shows horizontal cross sections of two heat exchangers;
- Figure 13: shows a horizontal cross section of a further heat exchanger; and
- Figure 14: shows three alternative types of end pieces.

### Detailed Description of Exemplary Embodiments

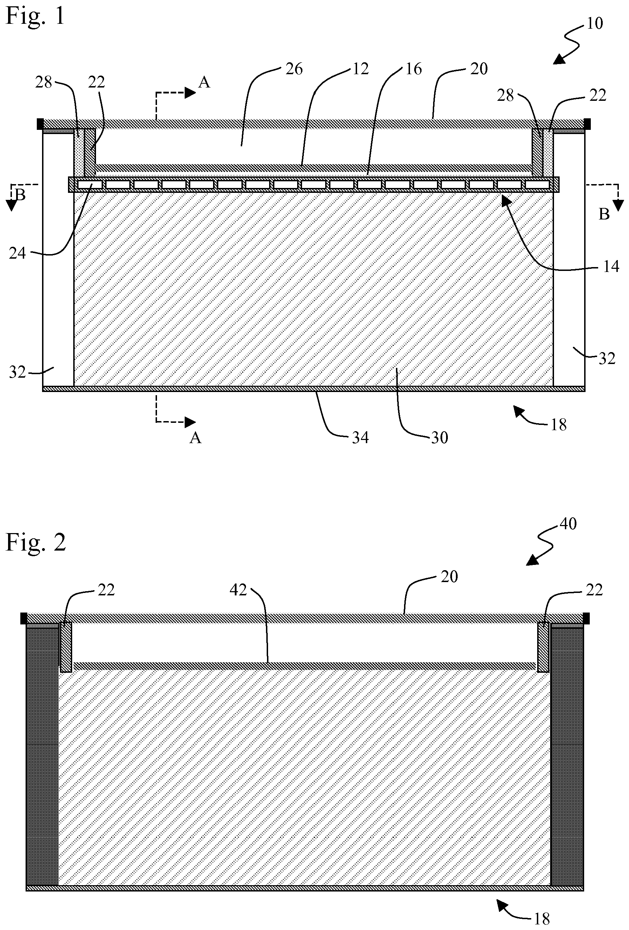

Figure 1 shows a cross section of a first solar device 10 which is suitable for use in constructing a building. The embodiment comprises a sheet of Photovoltaic (PV) cells 12, adhered to a first heat exchanger 14 by a layer of adhesive 16 which provides good thermal conduction. The first heat exchanger 14 is attached to and supported by the support member 18. The PV cells 12 are protected by a sheet of low iron glass 20; which is held above them by spacer bars 22. The first solar device 10 is a rigid, self supporting structure, which can easily be attached to a framework when constructing a building in order to form one of the walls or the roof of that building. When exposed to sunlight, the first solar device 10 will produce both electricity and hot water.

The PV cells 12 are thin film semiconductor cells which use a thin layer of amorphous silicon to generate electricity from sunlight. These cells 12 are produced in a flexible sheet and can easily be used to cover a large area. Their flexibility means that embodiments can be produced with curved surfaces if desired. The first heat exchanger 14 is produced by extrusion, and it can also be shaped when curved embodiments are required.

There are several parallel channels 24 set into the first heat exchanger 14. In use, the channels 24 are filled with water. When sunlight is shining on the first solar device 10, the PV cells 12 are heated up and this thermal energy is conducted through the adhesive layer 16 to the first heat exchanger 14. The water in the channels 24 absorbs the heat. This has two advantages. Firstly, the PV cells are cooled and can therefore work more efficiently. Secondly, the heated water in the channels 24 can be pumped out of the first solar device 10 for use. In order to avoid breaking the seal which maintains the low pressure in the channels 24, the heated water will usually be pumped through a sealed coil inside a tank which contains more water, which will then be heated by conduction. This will serve to cool down the water from the first solar device 10 before it is returned to the channels 24.

The sheet of glass 20 helps to prevent the loss of heat due to convection, and hence ensures that hotter water is produced by the first heat exchanger. Low iron glass is used for the sheet of glass 20 because it provides good light transmittance at a wide range of frequencies. The space 26 between the glass and the PV cells is filled with argon. Argon is used because it is inert, largely transparent and has very low thermal conductivity. A sealant 28 is provided around the spacer bars 22 in order to prevent the argon leaking.

The support member 18 is composed of two parts, an inner core of insulating material 30 and an outer layer of stiffening material 32, 34. The inner core 30 is polyurethane foam which provides insulation for a building constructed using the first solar devices 10, as it has very low thermal conductivity. In particular, the used of insulation reduces the heat loss that might otherwise occur through the metal components in and surrounding the PV cells 12. In operation, this low conductivity also helps to reduce heat loss from the first heat exchanger 14 and provides insulation to the building. Other insulating materials can be used, and set such that building codes are complied with The outer layer comprises two rafters 32 fixed to a facing board 34, and serves to protects the inner core 30 and strengthens the support member 18 so that the member can act as a support for the rest of the first solar device 10. As can be seen in Figure 1, the first heat exchanger 14 sits partly within a recess cut for it in the rafters 32 so that it can be held firmly in place. The rafters 32 and facing board 34 will typically be wooden, but they may also comprise plastic, composite materials such as glass reinforced plastic, concrete or steel for example. Alternative fixing approaches can be used, including using the insulating material 30 as a fixing/adhesive.

The facing board 34 used in the first solar device 10 is of a suitable quality and appearance that it can be left as the inner surface of a roof or wall if desired. However, inner facings such as plasterboard, timber, or soundproofing materials can easily be fitted in addition or as an alternative when required.

Figure 2 shows a dummy solar device 40, also for use in constructing buildings. The dummy solar device 40 comprises a support member 18, similar to the first solar device 10. It also comprises a sheet of glass 20 which is held above the support member 18 by spacer bars 22. However, there are no PV cells and no first heat exchanger, and the space beneath the glass is not filled with argon. The dummy solar device is sealed and provided with inhibitors to prevent a build-up of water vapour and/or microbes. Instead, a thin layer of coloured material 42, chosen to look like PV cells, is attached to the support member 18 so that the dummy solar device 40 is similar in appearance to the first solar device 10. Dummy solar devices can be used in combination with embodiments as described above, alongside those embodiments that only collect heat and/or generate electricity. Walls or roofs constructed from these combinations of devices are seamless in appearance, as the external cover can be the same in all instances.

The dummy solar device 40 is intended for use in buildings that also use the first solar device 10. The dummy solar device 40 is a cheaper and less delicate than the first solar device 10, and is therefore suitable for use on sections of wall or roof which do not receive enough sunlight to make the use of a first solar device 10 cost efficient. This allows the building to posses a uniform appearance without sudden jarring changes of texture between, for example, the north and south facing walls.

In use, both the first solar device 10 and the dummy solar device 40 are typically fastened to a conventional framework of wooden beams, concrete, steel or any other suitable material to form part of a roof or wall in the building which is being constructed. The device provides external weather proofing, insulation and outerleaf structural elements as well as providing a means for converting solar energy to heat or power.

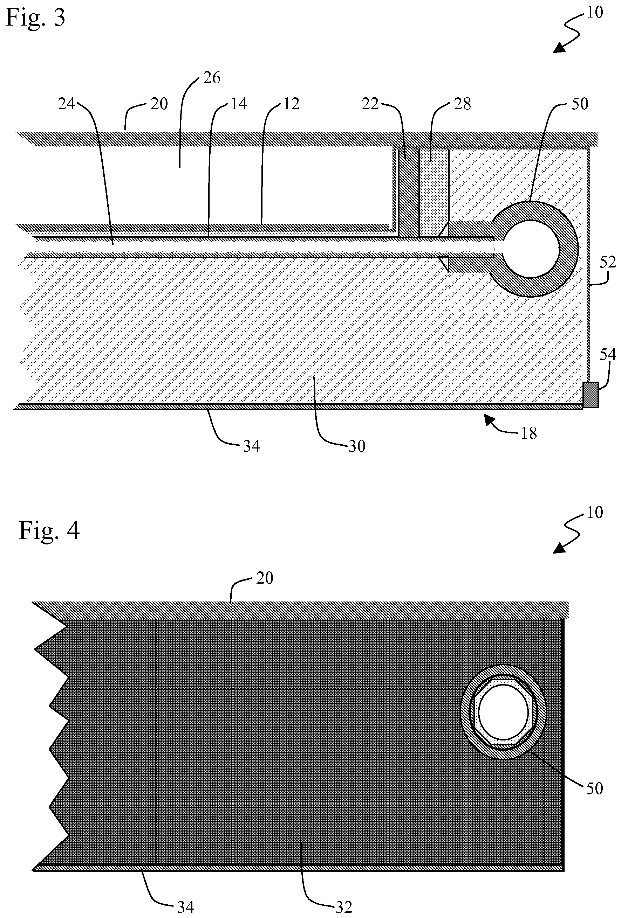

Figure 3 shows a longitudinal cross section of the first solar device 10, this cross section taken through line A in Figure 1. As can be seen in Figure 3, the channels 24 in the first heat exchanger 14 are connected to a first end piece 50. The first end piece 50 is itself hollow, to allow water to be moved into the channels 24. The fluid then travels the length of the channel, which has been cut to the length that the roof demands, and then exits through a first end piece 50 at the opposite end of the device. An electrical connection 52 comprising a bundle of wires connects the PV cells 12 to a junction box 54 on the outside of the first solar device 10. The electrical connection 52 is run through a hole provided in the spacer bar 22 and the inner core 30 of support member 18 for this purpose. Sealant 28 is also packed around the electrical connection 52 to prevent argon from leaking from the space 26 beneath the glass 20. The electrical connection can be made at either end of the device.

Figure 4 shows a longitudinal section of the first solar device 10 as Figure 3, but from the side. The first end piece 50 extends through the rafter 32 so that the first heat exchanger 14 can be connected to a pump or siphon or to a first heat exchanger in an adjoining first solar device 10.

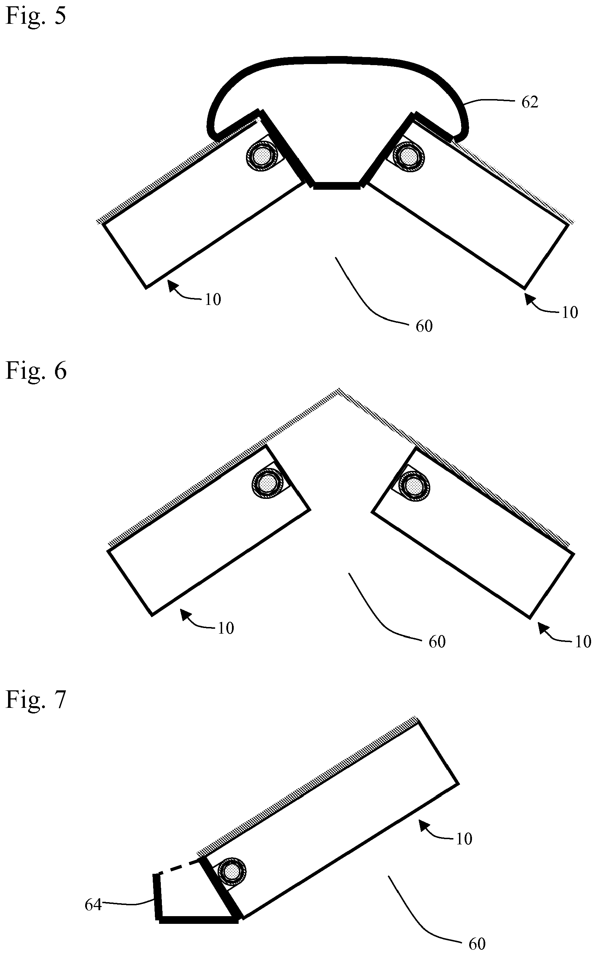

Figures 5, 6 and 7 show the first solar device 10 in use. In Figure 5, the ends of two first solar devices 10 are positioned at the apex so as to form a roof space 60. An insulated capping piece 62 is fitted over the ends of the first solar devices 10 in order to seal the roof. Figure 6 shows a similar installation, except that the roof space 60 has been sealed by extending the glass 20 at the end of each first solar device 10 and sealing the two sheets of glass together at the apex. Figure 7 shows the end of a first solar device 10 over a roof space 60 at the eve that has been fitted with a gutter 64. The first solar device 10 in Figure 7 shows only one first end piece 50 located at the lower end of the device. Another first end piece 50 is located at the upper end of the device. Providing connections through this lower end will often be the most convenient solution where pipes and wiring are being fed through walls to reach the roof.

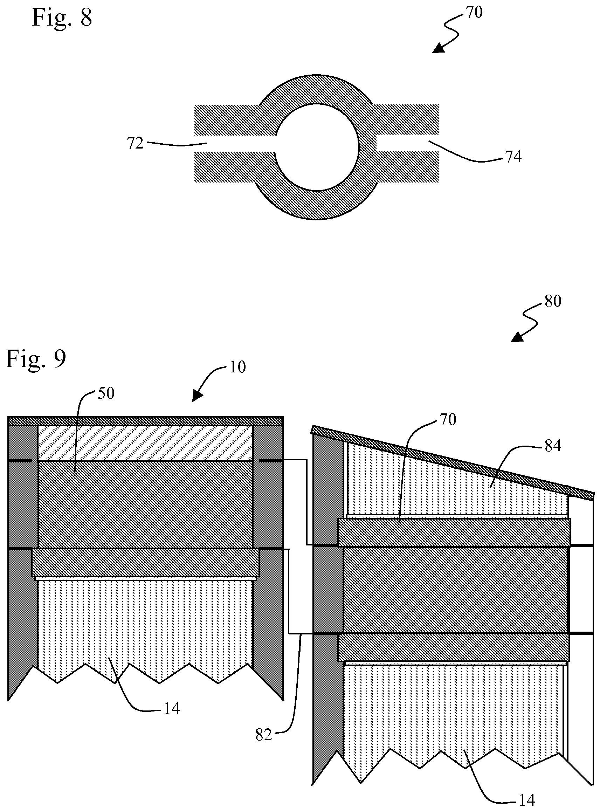

Figure 8 shows a second end piece 70 which is fitted with both a first connector 72 and a second connector 74. The second end piece 70 is intended for use in situations such as the one shown in Figure 9. Here a first solar device 10 is shown on the left, in a cross section taken through line B in Figure 1. The first solar device 10 in Figure 9 forms part of a hipped roof, and in order to accommodate the slope of the roof a second solar device 80 is used The second solar device 80 comprises a first heat exchanger 14 which is connected to the first connector 72 and operates in the usual manner through a second end piece 70. The second solar device 80 also comprises a fin heat exchanger 84 which has been cut to provide a sloping edge. This fin heat exchanger 84 uses a solid metal fin rather than water in a channel to conduct heat, and is therefore practical for use over this short distance and with an end piece only on one side. The fin heat exchanger is connected to the second connector 74 of the second end piece 70 so as to provide a seamless appearance for the roof. PV cells 12 can also be used on the upper part of the solar device 80, over fin heat exchanger 84, if desired. As the roof slopes, the two solar devices are at different heights, and the first solar device 10 is joined to the second solar device 80 with a joining piece 82:

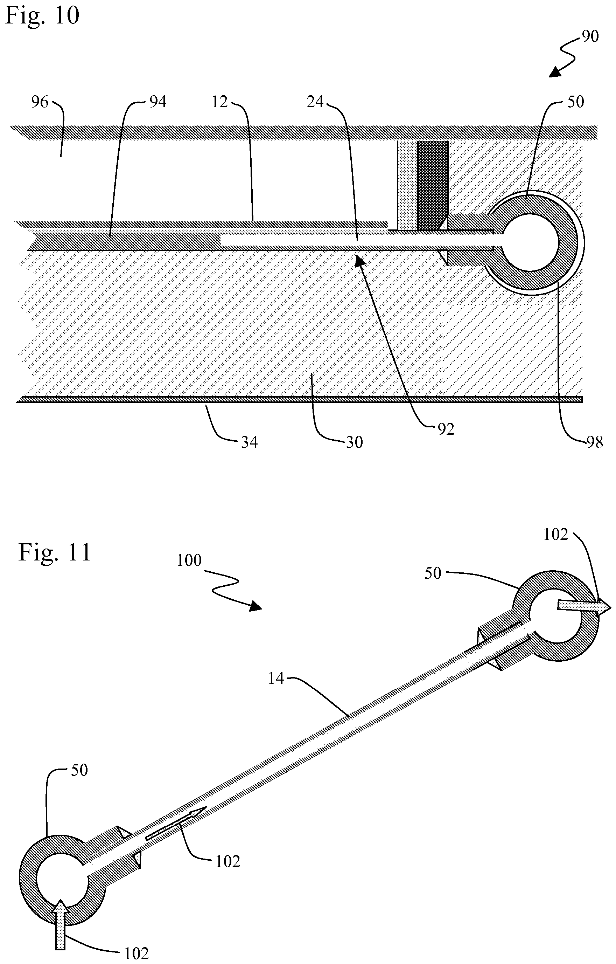

Figure 10 shows a cross section of a third solar device 90 which incorporates a second heat exchanger 92. The second heat exchanger 92 uses channels 24 filled with water vapour to absorb heat. The channels 24 in the second heat exchanger 92 are substantially evacuated except for a volume of water much smaller, when condensed, than the volume of the channels. The water is therefore gaseous at most temperatures due to the low pressure. The channels 24 only extend part way along the third solar device 90. Metal fins 94, which are adhered to the underside of the PV cells 12, run the rest of the length of the third solar device 90, and conduct heat to the channels 24. This embodiment has the advantage that it can be more easily cut to size without damaging the second heat exchanger 92. The second heat exchanger 92 also does not rely on a pump to move the water in the channels 24. Instead, the heat exchanger functions as a heat pipe, the heated water vapour within the channel 24 moving due to convection currents into the first end piece 50 so that it can heat water circulating around the first end piece 50 in manifold 98. Furthermore, the space 96 between the glass 20 and the PV cells 12 of the third solar device 90 is evacuated to minimise heat loss rather than being filled with argon.

Figure 11 shows a longitudinal cross section of a heat exchanger 14 connected to two end pieces 50. The arrows 102 indicate the flow of water through the heat exchanger in operation.

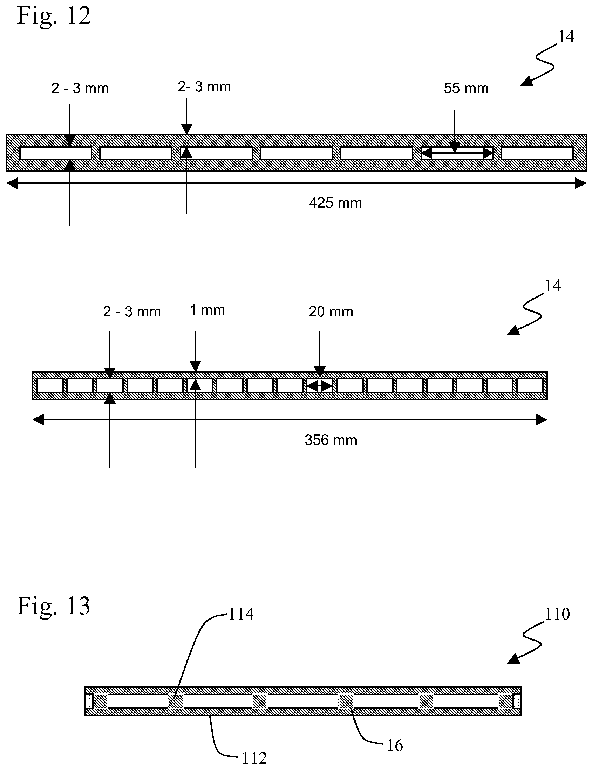

Figure 12 shows horizontal cross sections of two heat exchangers 14 according to two embodiments, with the dimensions of each heat exchanger marked. These heat exchangers are manufactured using extrusion. Figure 13 shows a further heat exchanger 110 which has been constructed from two plates 112 bonded to spacers 114 using an adhesive 16.

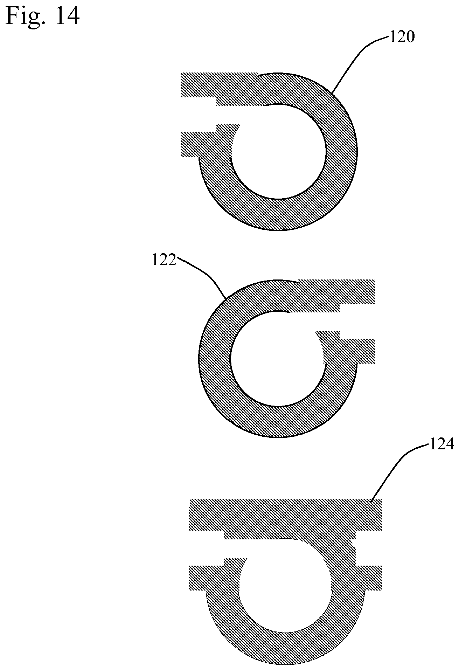

Figure 14 shows three alternative types of end pieces 120, 122 and 124. These end pieces have a flattened upper surface so that if they are left exposed, rather than having polyurethane packed on top of them, a sheet of PV cells 12 can be laid over the end piece 120, 122 or 124.

Although thin film semiconductor PV cells 12 are used in the embodiments described above, other solar to power conversion technologies can be used. For example, crystalline silicon cells may be used. Similarly, the transparent protective sheet 20 need not be low iron glass, which is expensive. Other protective covers can be used, such as polycarbonate.

The heat exchanger 14 described above uses water contained in channels to transport heat. However, other types of heat exchangers, such as fin, coil or heat pipe heat exchangers, can be used. The heat exchanger may also combine different techniques to transport the heat as desired. Where a fluid medium is used to transport the heat, that fluid will typically be water, but it may be some other suitable substance.

In the embodiments shown in figures 1 to 14, a chemical adhesive 16 is used to bond the components together. However, the components can also be bonded using mechanical means such as screws and nails, through welding, and by electromagnetic fastening or any other suitable means.

## Claims

1. A power generation member adapted to be attached to a framework to form a wall or roof of a building, the power generation member being a self-supporting structural unit (10) comprising a first, a second and a third layers,
- wherein the first layer is a support member (18) to which the second and third layers are attached, the support member comprising insulating material (30) laid within a structure (32, 34) formed from a supporting material made of wood, or metal, or concrete, or plastic, or glass reinforced plastic,
- wherein the second layer comprises a photovoltaic device (12) bonded to a thermal collector (14), and
- wherein the third layer is positioned in a different plane from the second layer and substantially parallel with it, the third layer being: -
- either a thermal collector of high thermal conductivity situated between the first and second layers, to allow rapid conduction of heat to the transmission fluid held in the pipe of the thermal collector in use, so maximising the absorption of heat from the second layer,
- or a substantially transparent thermal collector secured over the second layer, with fluid passing through the thermal collector in use to absorb heat from the second layer.

2. A power generation member according to claim 1, wherein the power generating member further comprises a protective layer, the protective layer being secured over the second layer when the third layer is beneath the second layer or over the third layer when it is above the second layer.

3. A power generation member as claimed in claim 2, wherein the protective layer is transparent.

4. A power generation member as claimed in claims 2 and 3, wherein the protective layer has good transmittance characteristics in the solar spectrum.

5. A power generation member as claimed in claims 2 to 4, wherein the protective layer comprises a low emissivity coating.

6. A power generation member as claimed in claims 2 to 5, wherein the space beneath the protective layer is evacuated or filled with argon, carbon dioxide, or some other light transmitting, insulating material or gas so as to further increase the retention of heat.

7. A power generation member as claimed in claims 2 to 5 and in instances of claim 6 where the space is not evacuated, wherein the space beneath the protective layer contains inhibitors to prevent a build-up of water vapour and/or microbes.

8. A power generation member according to claims 1 to 7 wherein the third layer lies beneath the second layer and is a heat pipe.

9. A power generation member according to claim 1 to 7 but wherein the third layer is beneath the second layer and comprises solid heat conductors such as fins that conduct heat to a desired destination.

## Patentansprüche

1. Energieerzeugungselement, das angepasst ist, um an einen Rahmen angebracht zu werden, um eine Wand oder ein Dach eines Gebäudes zu formen, wobei das Energieerzeugungselement eine selbsttragende Struktureinheit (10), umfassend eine erste, eine zweite und eine dritte Schicht, umfasst,
- wobei die erste Schicht ein Stützelement (18) ist, an das die zweite und dritte Schicht angebracht sind, wobei das Stützelement ein Dämmmaterial (30) umfasst, das in einer Struktur (32, 34) verlegt ist, die aus einem aus Holz oder Metall oder Beton oder Kunststoff oder glasverstärktem Kunststoff hergestellten Stützmaterial geformt ist,
- wobei die zweite Schicht eine Photovoltaikvorrichtung (12) umfasst, die mit einem Wärmesammler (14) verbunden ist und
- wobei die dritte Schicht in einer von der zweiten Schicht unterschiedlichen und im Wesentlichen parallel dazu verlaufenden Ebene positioniert ist, wobei die dritte Schicht: -
- entweder ein Wärmesammler mit hoher Wärmeleitfähigkeit, der zwischen der ersten und zweiten Schicht angeordnet ist, um eine schnelle Leitung der Wärme an das in Gebrauch in der Leitung des Wärmesammlers gehaltene Übertragungsfluid zu ermöglichen und so die Absorption der Wärme von der zweiten Schicht zu maximieren,
- oder ein im Wesentlichen transparenter Wärmesammler ist, der über der zweiten Schicht befestigt ist, wobei in Gebrauch Fluid den Wärmesammler durchläuft, um Wärme von der zweiten Schicht zu absorbieren.

2. Energieerzeugungselement nach Anspruch 1, wobei das Energieerzeugungselement ferner eine Schutzschicht umfasst, wobei die Schutzschicht über der zweiten Schicht, wenn sich die dritte Schicht unter der zweiten Schicht befindet, oder über der dritten Schicht befestigt ist, wenn sie sich über der zweiten Schicht befindet.

3. Energieerzeugungselement nach Anspruch 2, wobei die Schutzschicht transparent ist.

4. Energieerzeugungselement nach den Ansprüchen 2 und 3, wobei die Schutzschicht gute Übertragungseigenschaften im Solarspektrum aufweist.

5. Energieerzeugungselement nach den Ansprüchen 2 bis 4, wobei die Schutzschicht eine Beschichtung mit niedrigem Emissionsvermögen umfasst.

6. Energieerzeugungselement nach den Ansprüchen 2 bis 5, wobei der Raum unter der Schutzschicht evakuiert oder mit Argon, Kohlendioxid oder einem anderen lichtübertragenden, dämmenden Material oder Gas gefüllt ist, um das Halten von Wärme weiter zu erhöhen.

7. Energieerzeugungselement nach den Ansprüchen 2 bis 5 und in Teilen nach Anspruch 6, wobei der Raum nicht evakuiert ist, wobei der Raum unter der Schutzschicht Inhibitoren enthält, um ein Ansammeln von Wasserdampf und/oder Mikroben zu verhindern.

8. Energieerzeugungselement nach den Ansprüchen 1 bis 7, wobei die dritte Schicht unter der zweiten Schicht liegt und eine Wärmeleitung ist.

9. Energieerzeugungselement nach den Ansprüchen 1 bis 7, aber wobei die dritte Schicht unter der zweiten Schicht liegt und massive Wärmeleiter umfasst, wie Rippen, die Wärme zu einem erwünschten Ziel leiten.

## Revendications

1. Élément de génération d'énergie adapté pour être fixé sur un bâti pour former une paroi ou toit d'un bâtiment, l'élément de génération d'énergie étant une unité structurelle autoportante (10) comprenant une première, une deuxième, et une troisième couches,
- la première couche étant un élément de support (18) sur lequel sont fixées les deuxième et troisième couches, l'élément de support comprenant un matériau isolant (30) placé au sein d'une structure (32, 34) composé d'un matériau de support réalisé en bois, ou en métal, en béton, en plastique, ou en plastique renforcé à la fibre de verre,
- la deuxième couche comprenant un dispositif photovoltaïque (12) fixé à un collecteur thermique (14), et
- la troisième couche étant positionnée dans un plan différent de celui de la deuxième couche, et substantiellement parallèle à celui-ci, la troisième couche étant :
- soit un collecteur thermique à conductivité thermique élevée, situé entre les première et deuxième couches afin de permettre une conduction rapide de la chaleur au fluide de transmission contenu dans le tuyau du collecteur thermique en cours d'utilisation, de façon à maximiser l'absorption de la chaleur provenant de la deuxième couche,
- soit un collecteur thermique substantiellement transparent, fixé au-dessus de la deuxième couche, le fluide traversant le collecteur thermique en cours d'utilisation afin d'absorber de la chaleur provenant de la deuxième couche.

2. Élément de génération d'énergie selon la revendication 1, l'élément de génération d'énergie comprenant en outre une couche de protection, la couche de protection étant fixée au-dessus de la deuxième couche lorsque la troisième couche se trouve au-dessous de la deuxième couche, ou sur la troisième couche lorsqu'elle se trouve au-dessus de la deuxième couche.

3. Élément de génération d'énergie selon la revendication 2, la couche de protection étant transparente.

4. Élément de génération d'énergie selon les revendications 2 et 3, la couche de protection présentant de bonnes caractéristiques de transmittance dans le spectre solaire.

5. Élément de génération d'énergie selon les revendications 2 à 4, la couche de protection comprenant un revêtement à faible émissivité.

6. Élément de génération d'énergie selon les revendications 2 à 5, l'espace situé sous la couche de protection étant évacué ou rempli avec de l'argon, du dioxyde de carbone, ou tout autre matériau isolant ou gaz photoémetteur, de façon à accroître encore davantage la rétention de chaleur.

7. Élément de génération d'énergie selon les revendications 2 à 5, et, dans certains cas, la revendication 6, où l'espace n'est pas évacué, l'espace sous la couche de protection contenant des inhibiteurs pour la prévention d'une accumulation de vapeur d'eau et/ou de microbes.

8. Élément de génération d'énergie selon les revendications 1 à 7, la troisième couche se trouvant sous la deuxième couche, et étant un caloduc.

9. Élément de génération d'énergie selon les revendications 1 à 7, mais la troisième couche se trouvant sous la deuxième couche, et comprenant des conducteurs thermiques solides, par exemple des ailettes, conduisant la chaleur à une destination désirée.
